# EUROPEAN PATENT APPLICATION

(11) **EP 4 588 557 A1**
(43) Date of publication of application: **23.07.2025**
(21) Application number: 23936795.6
(22) Date of filing: 07.12.2023
(51) Int. Cl.: B01F 33/80, B01F 33/81, B01F 35/71, B01F 23/40, B01F 23/43, B01F 27/1143, B01F 35/21, B01F 101/00

(54) **MIXING SYSTEM**

(30) Priority: 01.12.2023 KR 20230172316
(71) Applicant: Nagase Engineering Service Korea Co., Ltd., Dongan-gu Anyang-si, Geonggi-do 14048 (KR)
(72) Inventor: KIM, Jae Gu, Seoul 06990 (KR)
(74) Representative: Jung, Minkyu
(86) International application number: PCT/KR2023/020093
(87) International publication number: WO 2025/116101

(57) **Abstract**

The present invention relates to a mixing system including: a first mixing device simultaneously supplied with ultrapure water and a highly concentrated chemical substance to generate a first mixture by mixing the ultrapure water and the highly concentrated chemical substance; a first transfer line connected to the first mixing device to transfer the first mixture; a second mixing device formed on the first transfer line to generate a second mixture by mixing the first mixture again; a mixing tank connected to the first transfer line, supplied with the second mixture, and configured to store a third mixture generated by mixing the supplied second mixture again by a third mixing device; a second transfer line connected to the mixing tank to transfer the third mixture; a storage tank connected to the second transfer line, supplied with the third mixture, and configured to store a fourth mixture generated by mixing the supplied third mixture again by a fourth mixing device; and a third transfer line connected to the storage tank to transfer the fourth mixture. According to the present invention, the highly concentrated chemical substance and the ultrapure water are mixed and used at a point of use through the mixing system, so that an amount of highly hazardous chemical substances transported is minimized, and thus logistics costs are reduced, and environmental pollution and human casualties caused by accidents occurring during the transport are minimized.

## Description

### [Technical Field]

The present invention relates to a mixing system, and more particularly, to a mixing system in which a highly concentrated chemical substance and ultrapure water are mixed and used at a point of use through the mixing system, so that an amount of highly hazardous chemical substances transported is minimized, and thus logistics costs are reduced, and environmental pollution and human casualties caused by accidents occurring during the transport are minimized.

### [Background Art]

Various liquid-state chemical substances are used in a process of manufacturing advanced industrial products such as semiconductors and displays. Such chemical substances are transported from a manufacturing site to a point of use by various transportation methods.

Recently, in the process of manufacturing semiconductors, displays, and the like, manufacturing patterns have become finer, and production has surged, so that an amount of chemical substances used is being significantly increased.

As the amount of chemical substances used is being increased, an amount of chemical substances transported is also being increased. However, as the amount of chemical substances transported is increased, cases in which the chemical substances leak to an outside due to accidents occurring during the transport are occurring frequently, leading to frequent environmental pollution, human casualties, and the like.

### [Disclosure]

### [Technical Problem]

To solve the problems described above, an object of the present invention is to provide a mixing system in which a highly concentrated chemical substance and ultrapure water may be mixed and used at a point of use through the mixing system, so that an amount of highly hazardous chemical substances transported may be minimized, and thus logistics costs may be reduced, and environmental pollution and human casualties caused by accidents occurring during the transport may be minimized.

### [Technical Solution]

To achieve the object described above, according to the present invention, there is provided a mixing system including: a first mixing device configured to simultaneously receive ultrapure water and a highly concentrated chemical substance to generate a first mixture by mixing the ultrapure water and the highly concentrated chemical substance; a first transfer line connected to the first mixing device to transfer the first mixture; a second mixing device formed on the first transfer line to generate a second mixture by mixing the first mixture again; a mixing tank connected to the first transfer line to receive the second mixture, and configured to store a third mixture generated by mixing the received second mixture again by a third mixing device; a second transfer line connected to the mixing tank to transfer the third mixture; a storage tank connected to the second transfer line to receive the third mixture, and configured to store a fourth mixture generated by mixing the received third mixture again by a fourth mixing device; and a third transfer line connected to the storage tank to transfer the fourth mixture.

In addition, according to the present invention, the mixing system may further include: a supply adjustment unit configured to adjust a supply ratio of the ultrapure water and the highly concentrated chemical substance supplied to the first mixing device; a flow rate measurement unit configured to measure flow rates of the supplied ultrapure water and the supplied highly concentrated chemical substance; and a concentration measurement unit configured to measure a concentration of the third mixture.

In this case, the supply adjustment unit may adjust the supply ratio of the ultrapure water and the highly concentrated chemical substance by controlling a supply pressure of the highly concentrated chemical substance according to a supply pressure of the ultrapure water.

In addition, the supply adjustment unit may be repeatedly changed the concentration of the third mixture by adjusting the supply ratio of the ultrapure water and the highly concentrated chemical substance.

In addition, the second transfer line may have one side connected to a lower portion of the mixing tank and an opposite side connected to a side surface of the storage tank.

Meanwhile, according to the present invention, the mixing system may further include: a concentration measurement unit configured to measure a concentration of the fourth mixture stored in the storage tank; an ultrapure water supply unit configured to supply the ultrapure water to the storage tank; a highly concentrated chemical substance supply unit configured to supply the highly concentrated chemical substance to the storage tank; and a flow rate measurement unit configured to measure flow rates of the ultrapure water and the highly concentrated chemical substance, which are supplied to the storage tank.

In this case, when the concentration of the fourth mixture measured by the concentration measurement unit does not match a reference concentration, the ultrapure water and/or the highly concentrated chemical substance may be supplied to the storage tank through the ultrapure water supply unit and/or the highly concentrated chemical substance supply unit to allow the concentration of the fourth mixture to match the reference concentration.

In addition, an inner space of the mixing tank and an inner space of the storage tank may have different volumes.

In addition, the inner space of the mixing tank may be smaller than the inner space of the storage tank.

In addition, according to the present invention, the mixing system may further include a first circulation line having one side connected to a lower portion of the mixing tank and an opposite side connected to an upper portion of the mixing tank, and configured to circulate the third mixture inside the mixing tank.

In addition, according to the present invention, the mixing system may further include: a second circulation line branched from the third transfer line, and connected to an upper portion of the storage tank; and an opening/closing valve formed on the second circulation line to open and close the second circulation line.

### [Advantageous Effects]

Accordingly, according to the present invention, the highly concentrated chemical substance and the ultrapure water may be mixed and used at a point of use through the mixing system, so that an amount of highly hazardous chemical substances transported can be minimized, and thus logistics costs can be reduced, and environmental pollution and human casualties caused by accidents occurring during the transport can be minimized.

In addition, according to the present invention, the highly concentrated chemical substance and the ultrapure water may be mixed again by a plurality of mixing devices, so that a large-volume mixture solution can be manufactured while maintaining an ultra-precise concentration.

### [Description of Drawings]

FIG. 1 is a view showing an overall concept of a mixing system according to the present invention.
FIG. 2 is a view showing a first mixing device of the mixing system according to the present invention.
FIG. 3 is a view showing a mixing tank of the mixing system according to the present invention.
FIG. 4 is a view showing a storage tank of the mixing system according to the present invention.
FIG. 5 is a graph showing concentrations of mixtures in the mixing tank and the storage tank of the mixing system according to the present invention.

### [Mode for Invention]

With respect to embodiments according to the concept of the present invention disclosed herein, specific structural or functional descriptions have been illustrated to describe the embodiments according to the concept of the present invention only, so that the embodiments according to the concept of the present invention may be implemented in various forms and are not limited to the embodiments described herein.

Since various changes can be made to the embodiments according to the concept of the present invention, and the embodiments according to the concept of the present invention may have various forms, the embodiments will be illustrated in the drawings and described in detail herein. This, however, is by no means to restrict the embodiments according to the concept of the present invention to specific disclosed forms, and the embodiments according to the concept of the present invention may encompass modifications, equivalents, or substitutes included in the idea and technical scope of the present invention.

The terms such as "first" or "second" may be used to describe various elements, but the elements should not be limited by the terms. The terms may be used to distinguish one element from another element only. For example, a first element may be termed as a second element, and similarly, a second element may be termed as a first element, without departing from the scope according to the concept of the present invention.

When one element is described as being "connected" or "accessed" to another element, it shall be construed as being connected or accessed to the other element directly, but also as possibly having another element in between. Meanwhile, when one element is described as being "directly connected" or "directly accessed" to another element, it shall be construed that there is no other element in between. Other expressions describing the relation between elements, such as "between" and "directly between" or "adjacent to" and "directly adjacent to", should be interpreted similarly as described above.

The terms used herein are used to describe specific embodiments only, and shall by no means restrict the present invention. Unless the context explicitly indicates otherwise, an expression in a singular form includes a meaning of a plural form. In the present disclosure, a term such as "comprising" or "including" is intended to designate the presence of characteristics, numbers, steps, operations, elements, parts, or combinations thereof described herein, and shall not be construed to preclude any possibility of the presence or addition of one or more other characteristics, numbers, steps, operations, elements, parts, or combinations thereof.

Unless defined otherwise, all terms used herein, including technical or scientific terms, have the same meaning as those commonly understood by a person having ordinary skill in the art to which the present invention pertains. Any terms as those defined in generally used dictionaries shall be interpreted as having the meanings consistent with the contextual meanings in the relevant field of art, and shall not be interpreted as having idealistic or excessively formalistic meanings unless explicitly defined in the present disclosure.

Hereinafter, a mixing system according to an exemplary embodiment of the present invention will be described with reference to the accompanying drawings.

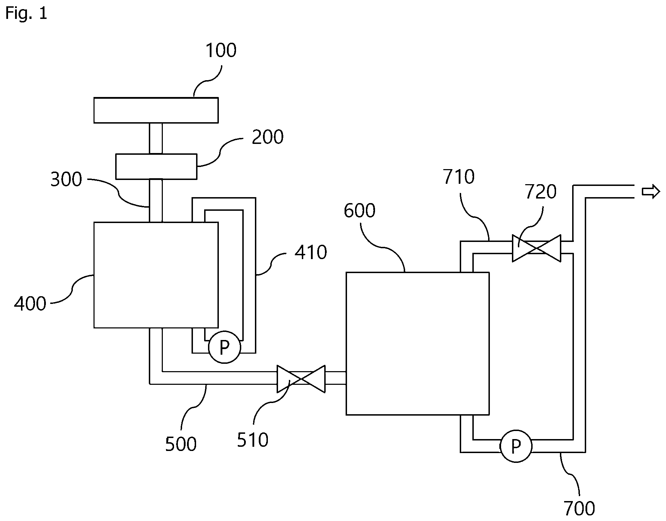

As shown in FIG. 1, the mixing system according to the present invention may include: a first mixing device 100 simultaneously supplied with ultrapure water and a highly concentrated chemical substance to generate a first mixture by mixing the ultrapure water and the highly concentrated chemical substance; a first transfer line 300 connected to the first mixing device 100 to transfer the first mixture; a second mixing device 200 formed on the first transfer line 300 to generate a second mixture by mixing the first mixture again; a mixing tank 400 connected to the first transfer line 300, supplied with the second mixture, and configured to store a third mixture generated by mixing the supplied second mixture again by a third mixing device 420; a second transfer line 500 connected to the mixing tank 400 to transfer the third mixture; a storage tank 600 connected to the second transfer line 500, supplied with the third mixture, and configured to store a fourth mixture generated by mixing the supplied third mixture again by a fourth mixing device 610; and a third transfer line 700 connected to the storage tank 600 to transfer the fourth mixture.

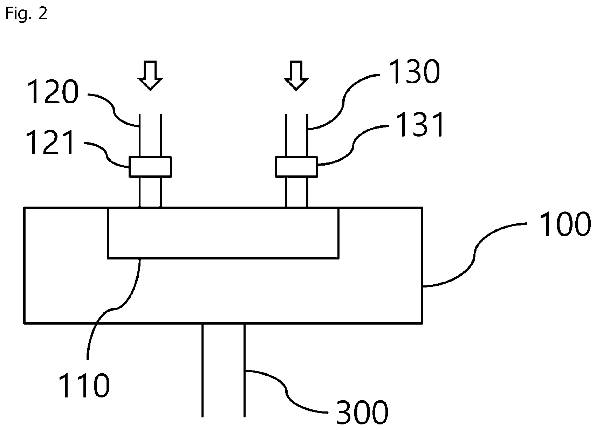

First, as shown in FIG. 2, the first mixing device 100 may be configured to generate the first mixture by mixing the ultrapure water and the highly concentrated chemical substance, and may include an ultrapure water supply unit 120 configured to supply the ultrapure water into the first mixing device 100 and a highly concentrated chemical substance supply unit 130 configured to supply the highly concentrated chemical substance into the first mixing device 100. The highly concentrated chemical substance supplied by the highly concentrated chemical substance supply unit 130 into the first mixing device 100 may be, as representative examples, a developer (tetramethylammonium hydroxide (TMAH)), ammonia water (NH₄OH), hydrofluoric acid (HF), and the like.

In addition, the ultrapure water supply unit 120 and the highly concentrated chemical substance supply unit 130 may include flow rate measurement units 121 and 131 to measure supply flow rates of the ultrapure water supply unit 120 and the highly concentrated chemical substance supply unit 130, respectively. In addition, a supply adjustment unit 110 configured to adjust a supply ratio of the ultrapure water supply unit 120 and the highly concentrated chemical substance supply unit 130 may be formed inside the first mixing device 100.

The first mixing device 100 described above may generate the first mixture by mixing the ultrapure water and the highly concentrated chemical substance supplied through the ultrapure water supply unit 120 and the highly concentrated chemical substance supply unit 130. In this case, the supply adjustment unit 110 may adjust the supply ratio of the ultrapure water and the highly concentrated chemical substance by controlling a supply pressure of the highly concentrated chemical substance according to a supply pressure of the ultrapure water. A concentration of the first mixture generated by the first mixing device 100 may have an error range of about 0.01%.

Meanwhile, the first transfer line 300 may be provided as a pipe or the like having a transfer space formed therein and having a predetermined diameter, and may have one side connected to the first mixing device 100 and an opposite side connected to the mixing tank 400.

In this case, the second mixing device 200 configured to mix the first mixture transferred through the first transfer line 300 again may be formed on the first transfer line 300. The second mixing device 200 described above may have a stirring member, such as a screw, formed therein to generate the second mixture by mixing the first mixture transferred through the first transfer line 300 again as the first mixture passes through the stirring member. The second mixture generated through the mixing again by the second mixing device 200 as described above may be transferred to the mixing tank 400 through the first transfer line 300. In this case, a concentration of the second mixture generated by the second mixing device 200 may have an error range of about 0.01%.

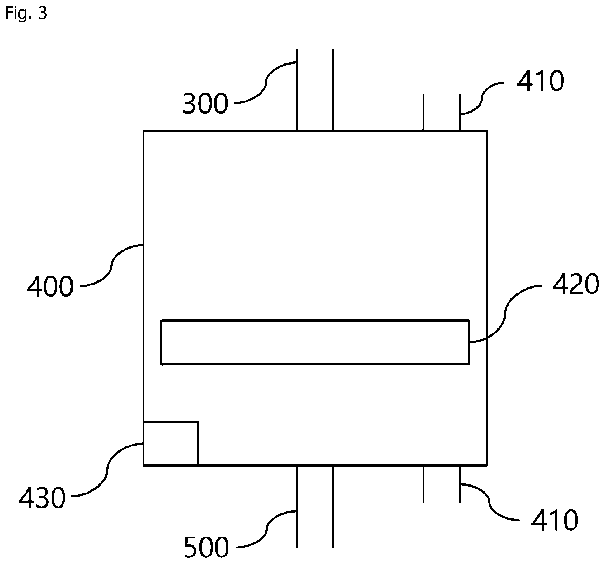

As shown in FIG. 3, the mixing tank 400 may be provided as a container having a storage space formed therein, and the inner storage space may be completely sealed from an outside.

The third mixing device 420 configured to mix the second mixture supplied through the first transfer line 300 again may be formed inside the mixing tank 400. The third mixing device 420 described above may be provided as a stirring member such as a screw to generate the third mixture by mixing the second mixture again as the second mixture passes through the stirring member. In addition, a concentration measurement unit 430 configured to measure a concentration of the third mixture may be formed inside the mixing tank 400. The concentration of the third mixture generated by the third mixing device 420 may have an error range of about 0.001%.

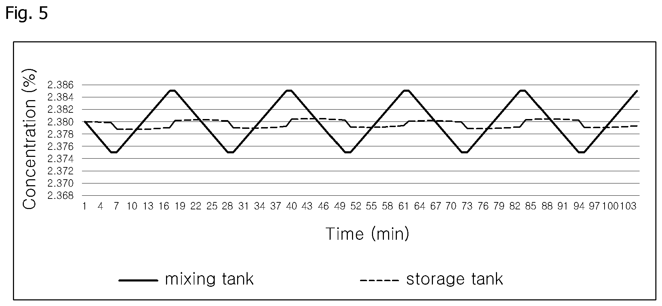

In this case, the supply adjustment unit 110 may be repeatedly changed the concentration of the third mixture by adjusting the supply ratio of the ultrapure water and the highly concentrated chemical substance. FIG. 5 is a graph showing concentrations of mixtures in the mixing tank 400 and the storage tank 600, in which the concentration of the third mixture inside the mixing tank 400 is repeatedly changed according to a sine curve. To describe the change in the concentration of the third mixture in detail, the concentration measurement unit 430 inside the mixing tank 400 may measure the concentration of the third mixture, and the supply adjustment unit 110 may adjust an amount of the ultrapure water supplied or the highly concentrated chemical substance supplied according to the measured concentration so that the concentration of the third mixture may be changed according to a sine curve. When the concentration of the third mixture is not changed according to the sine curve, the concentration may be maintained at an upper or lower limit of the error range, so that it may be difficult to maintain the concentration error of the third mixture at 0.01%, and thus it may become difficult to maintain a concentration of the fourth mixture within an error range. However, when the concentration of the third mixture is changed according to the sine curve, the concentration of the third mixture may be repeatedly changed from an upper limit of 0.01% to a lower limit of 0.01%, so that the error range of the concentration of the third mixture that is actually transferred into the storage tank 600 may converge to 0.01%.

In addition, a first circulation line 410 configured to circulate the third mixture inside the mixing tank 400 may be formed in the mixing tank 400. The first circulation line 410 may be provided as a pipe or the like having a transfer space formed therein and having a predetermined diameter, and may have one side connected to a lower portion of the mixing tank 400 and an opposite side connected to an upper portion of the mixing tank 400. In this case, a pump may be installed on the first circulation line 410 so that the third mixture inside the mixing tank 400 may be circulated through the first circulation line 410 by an operation of the pump. The pump of the first circulation line 410 described above may be operated according to a measurement value of the concentration measurement unit 430 inside the mixing tank 400 to circulate the third mixture. In other words, when the third mixture is not uniformly mixed or the measured concentration is different from the reference concentration as a result of the measurement of the concentration measurement unit 430, the pump of the first circulation line 410 may be operated to circulate the third mixture to the upper portion of the mixing tank 400 so that the third mixture may be mixed again by the third mixing device 420.

The second transfer line 500 may be provided as a pipe or the like having a transfer space formed therein and having a predetermined diameter, and may have one side connected to the lower portion of the mixing tank 400 and an opposite side connected to a side surface of the storage tank 600. Since the second transfer line 500 described above is connected to the lower portion of the mixing tank 400, the third mixture may be transferred into the storage tank 600 through free falling due to a weight of the third mixture. In this case, a purge valve 510 may be formed in the second transfer line 500 to prevent the third mixture transferred through the second transfer line 500 from making contact with air.

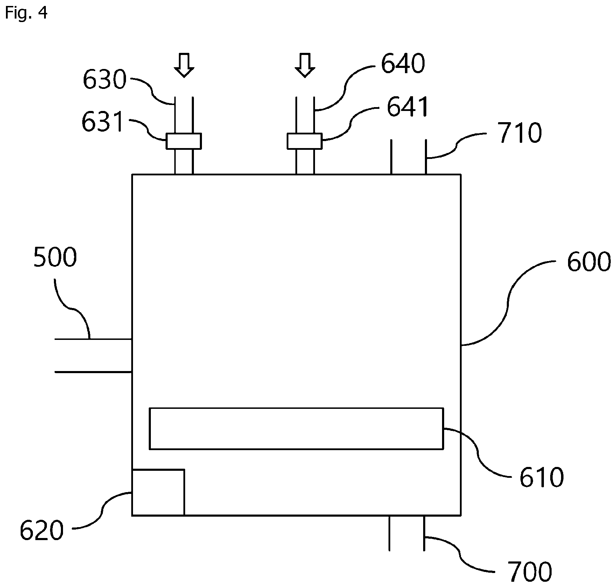

Meanwhile, as shown in FIG. 4, the storage tank 600 may be provided as a container having a storage space formed therein, and the inner storage space may be completely sealed from the outside.

The fourth mixing device 610 configured to mixing the third mixture supplied through the second transfer line 500 again may be formed inside the storage tank 600. The fourth mixing device 610 described above may be provided as a stirring member such as a screw to generate the fourth mixture by mixing the third mixture again as the third mixture passes through the stirring member. In this case, since the third mixture has to be mixed again by the fourth mixing device 610, the opposite side of the second transfer line 500 may be connected to the storage tank 600 so as to be located above the fourth mixing device 610.

In addition, a concentration measurement unit 620 configured to measure the concentration of the fourth mixture may be formed inside the storage tank 600, and an ultrapure water supply unit 630 configured to supply the ultrapure water into the storage tank 600 and a highly concentrated chemical substance supply unit 640 configured to supply the highly concentrated chemical substance may be formed. In this case, the ultrapure water supply unit 630 and the highly concentrated chemical substance supply unit 640 may include flow rate measurement units 631 and 641 to measure supply flow rates of the ultrapure water supply unit 630 and the highly concentrated chemical substance supply unit 640, respectively.

The concentration measurement unit 620 inside the storage tank 600 may measure the concentration of the fourth mixture. When the measured concentration of the fourth mixture does not match a reference concentration, the ultrapure water and/or the highly concentrated chemical substance may be supplied into the storage tank 600 through the ultrapure water supply unit 630 and/or the highly concentrated chemical substance supply unit 640 to allow the concentration of the fourth mixture to match the reference concentration. FIG. 5 is a graph showing the concentrations of the mixtures in the mixing tank 400 and the storage tank 600, in which the fourth mixture inside the storage tank 600 may maintain a uniform concentration through the process described above. Therefore, the concentration of the fourth mixture generated by the fourth mixing device 610 may have an error range of about 0.001%.

Inner storage spaces of the mixing tank 400 and the storage tank 600 described above may have different volumes, in which the inner storage space of the mixing tank 400 may be smaller than the inner storage space of the storage tank 600. In other words, the inner storage space of the storage tank 600 may have a larger volume than the inner storage space of the mixing tank 400. In this case, the inner storage space of the storage tank 600 may have a volume that is at least 50% larger than a volume of the inner storage space of the mixing tank 400. When the third mixture is transferred from the mixing tank 400 to the storage tank 600, the third mixture may be transferred through the second transfer line 500. The third mixture may be transferred from the mixing tank 400 to the storage tank 600 through a natural head due to a location in which the second transfer line 500 is installed. In other words, the third mixture may be continuously transferred in small quantities from the mixing tank 400 to the storage tank 600 through the second transfer line 500. Since only a small amount of the third mixture is transferred as described above as compared with a total volume of the storage tank 600, even when the third mixture having an error of 0.01% is supplied to the storage tank 600, an effect on the concentration of the fourth mixture stored in the storage tank 600 may be insignificant. As a size of the storage tank 600 becomes larger, the concentration of the fourth mixture may be maintained more uniformly regardless of the third mixture. Ideally, the storage tank 600 may be preferably about 300% or more larger than the mixing tank 400, but considering environmental constraints of the installation location, costs, and the like, the object described above may be achieved when the size of the storage tank 600 is at least 50% larger than a size of the mixing tank 400.

In addition, the third transfer line 700 may be provided as a pipe or the like having a transfer space formed therein and having a predetermined diameter, and may have one side connected to the storage tank 600 and an opposite side connected to a point of use, so that the fourth mixture inside the storage tank 600 may be transferred to the point of use through the third transfer line 700. In this case, the third transfer line 700 may include a pump to enable smooth transfer of the fourth mixture.

In this case, the third transfer line 700 may further include: a second circulation line 710 branched from the third transfer line 700, and connected to an upper portion of the storage tank 600; and an opening/closing valve 720 formed on the second circulation line 710 to open and close the second circulation line 710. The second circulation line 710 may be provided as a pipe or the like having a transfer space formed therein and having a predetermined diameter, and may have one side connected to the third transfer line 700 and an opposite side connected to the upper portion of the storage tank 600. When the concentration of the fourth mixture measured by the concentration measurement unit 620 inside the storage tank 600 is different from the reference concentration, the opening/closing valve 720 may be opened so that the fourth mixture may be circulated into the storage tank 600 through the third transfer line 700 and the second circulation line 710. In this case, although not shown, a separate opening/closing valve (not shown) may be additionally installed on the third transfer line 700 to prevent the fourth mixture from being transferred to the point of use when the fourth mixture is circulated through the second circulation line 710. The separate opening/closing valve (not shown) may be located toward the point of use as compared with a point at which the second circulation line 710 is branched. As described above, the fourth mixture circulated into the storage tank 600 through the second circulation line 710 may be mixed again by the fourth mixing device 610.

According to the mixing system of the present invention configured as described above, the highly concentrated chemical substance and the ultrapure water may be mixed and used at the point of use, so that an amount of highly hazardous chemical substances transported may be minimized, and thus logistics costs may be reduced, and environmental pollution and human casualties caused by accidents occurring during the transport may be minimized. In addition, the highly concentrated chemical substance and the ultrapure water may be mixed again by a plurality of mixing devices, so that a large-volume mixture solution may be manufactured while maintaining an ultra-precise concentration.

Accordingly, the mixing system according to the exemplary embodiment of the present invention has been described above.

The embodiments described above are illustrative in all respects, and should not be construed as limiting. The scope of the present invention will be defined by the appended claims rather than the detailed description set forth above. In addition, the scope of the present invention should be construed as encompassing all changes and modifications derived from the meaning and scope of the claims as well as the equivalent concept thereof.

## Claims

1. A mixing system comprising:
a first mixing device simultaneously supplied with ultrapure water and a highly concentrated chemical substance to generate a first mixture by mixing the ultrapure water and the highly concentrated chemical substance;
a first transfer line connected to the first mixing device to transfer the first mixture;
a second mixing device formed on the first transfer line to generate a second mixture by mixing the first mixture again;
a mixing tank connected to the first transfer line, supplied with the second mixture, and configured to store a third mixture generated by mixing the supplied second mixture again by a third mixing device;
a second transfer line connected to the mixing tank to transfer the third mixture;
a storage tank connected to the second transfer line, supplied with the third mixture, and configured to store a fourth mixture generated by mixing the supplied third mixture again by a fourth mixing device;
a third transfer line connected to the storage tank to transfer the fourth mixture;
a concentration measurement unit configured to measure a concentration of the fourth mixture stored in the storage tank;
an ultrapure water supply unit configured to supply the ultrapure water to the storage tank;
a highly concentrated chemical substance supply unit configured to supply the highly concentrated chemical substance to the storage tank; and
a flow rate measurement unit configured to measure flow rates of the ultrapure water and the highly concentrated chemical substance, which are supplied to the storage tank.

2. The mixing system of claim 1, wherein the second transfer line has one side connected to a lower portion of the mixing tank and an opposite side connected to a side surface of the storage tank.

3. The mixing system of claim 1, wherein, when the concentration of the fourth mixture measured by the concentration measurement unit does not match a reference concentration, the ultrapure water and the highly concentrated chemical substance are supplied to the storage tank through the ultrapure water supply unit and the highly concentrated chemical substance supply unit to allow the concentration of the fourth mixture to match the reference concentration.

4. The mixing system of claim 1, wherein an inner space of the mixing tank and an inner space of the storage tank have different volumes.

5. The mixing system of claim 4, wherein the inner space of the mixing tank is smaller than the inner space of the storage tank.

6. The mixing system of claim 1, further comprising a first circulation line having one side connected to a lower portion of the mixing tank and an opposite side connected to an upper portion of the mixing tank, and configured to circulate the third mixture inside the mixing tank.

7. The mixing system of claim 1, further comprising:
a second circulation line branched from the third transfer line, and connected to an upper portion of the storage tank; and
an opening/closing valve formed on the second circulation line to open and close the second circulation line.
